# EUROPEAN PATENT APPLICATION

(11) **EP 2 421 029 A1**
(43) Date of publication of application: **22.02.2012**
(21) Application number: 10764201.9
(22) Date of filing: 17.03.2010
(51) Int. Cl.: H01L 21/324, C30B 15/00, C30B 29/06, H01L 21/26

(54) **ANNEAL WAFER, METHOD FOR MANUFACTURING ANNEAL WAFER, AND METHOD FOR MANUFACTURING DEVICE**

(30) Priority: 13.04.2009 JP 2009096671
(71) Applicant: Shin-Etsu Handotai Co., Ltd., Tokyo 100-0004 (JP)
(72) Inventor: EBARA, Koji, Annaka-shi Gunma 379-0196 (JP); HAYAMIZU, Yoshinori, Nishishirakawa-gun Fukushima 961-8061 (JP); KIKUCHI, Hiroyasu, Nishishirakawa-gun Fukushima 961-8061 (JP)
(74) Representative: Wibbelmann, Jobst
(86) International application number: PCT/JP2010/001891
(87) International publication number: WO 2010/119614

(57) **Abstract**

The present invention provides an annealed wafer obtained by performing rapid thermal annealing on a silicon single crystal wafer sliced from a silicon single crystal ingot in which an entire plane is an OSF region, an N region outside an OSF region, or a mixed region thereof, the silicon single crystal ingot being grown by the Czochralski method, in which RIE defects do not exist in a region having at least a depth of 1 µm from a surface, a good chip yield of a TDDB characteristic is 80% or more, and a depth of a region where an oxygen concentration is decreased due to outward diffusion is within 3 µm from the surface, and a method for producing an annealed wafer. As a result, there is provided a wafer in which the strength of the surface layer thereof is sufficiently kept without a decrease in oxygen concentration of the surface layer due to outward diffusion as much as possible, the defects relevant to oxygen, such as oxide precipitates, COPs, and OSFs, do not exist, the grown-in defects also do not exist, and the TDDB characteristic is superior.

## Description

### TECHNICAL FIELD

The present invention relates to an annealed wafer having a defect-free region (Denuded zone, hereinafter referred to as a DZ layer) formed thereon, in which grown-in oxide precipitates, grown-in defects, and RIE defects (defects that can be detected by the RIE method) do not exist within a constant depth from a wafer surface, and particularly to an annealed wafer having characteristics that oxide dielectric breakdown voltage is superior, hillocks in a device process can be prevented from being formed, which may be generated in a step of processing a groove with a dry etching apparatus, a decrease in the oxygen concentration due to outward diffusion of the surface is suppressed on the wafer surface, the oxygen concentration distribution is uniform in a depth direction, and a decrease in wafer strength followed by a decrease in the oxygen concentration in the vicinity of a surface layer is suppressed, and to a method for producing the same, and to a method for fabricating a device by using the same.

### BACKGROUND ART

In recent years, as devices have become finer with an increase in the integration of semiconductor circuits, the quality demand for a silicon single crystal, which serves as a substrate of the devices, produced by the Czochralski method (hereinafter referred to as the CZ method) has been increased.

Incidentally, in a silicon single crystal grown by the CZ method, oxygen of approximately 10 to 20 ppma (JEIDA: use of a conversion factor by Japan Electronics and Information Technology Industries Association), which is dissolved from a quartz crucible, is generally taken in a silicon crystal at a silicon melt interface.
It thereafter becomes a supersaturation status in the course of cooling the crystal, and, when the temperature of the crystal becomes 700°C or less, it agglomerates to form oxide precipitates (hereinafter, referred to as grown-in oxide precipitates). Its size, however, is extremely small, and therefore a TZDB (Time Zero Dielectric Breakdown) characteristic, which is one of oxide dielectric breakdown voltage characteristics, and device characteristics are not decreased in the shipment stage of wafers.

It was proved that defects that are caused by single crystal growth and deteriorate the oxide dielectric breakdown voltage characteristics and device characteristics are complex defects and grown-in defects, such as FPD, LSTD, COP, and OSF nucleus. The complex defects are formed as a result that vacancy-type point defects called Vacancies (hereinafter also abbreviated as Va) that are taken in the silicon single crystal from a melt of crystals and interstitial silicon point defects called Interstitial-Silicon (hereinafter also abbreviated as I) become supersaturation during cooling the crystal and that they are agglomerated together with oxygen. Before explaining these defects, first, what is generally known about a factor determining each concentration of Va and I taken in the silicon single crystal will be explained.

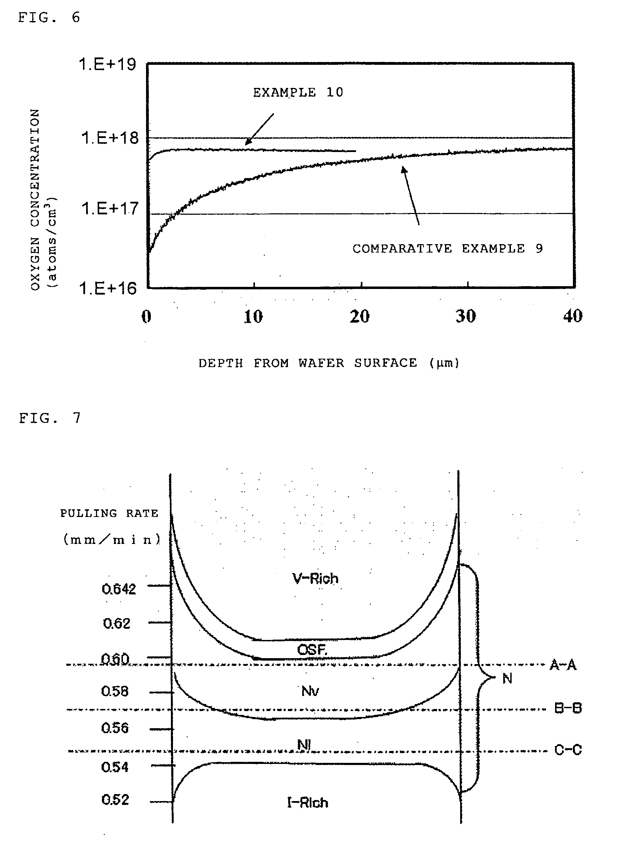

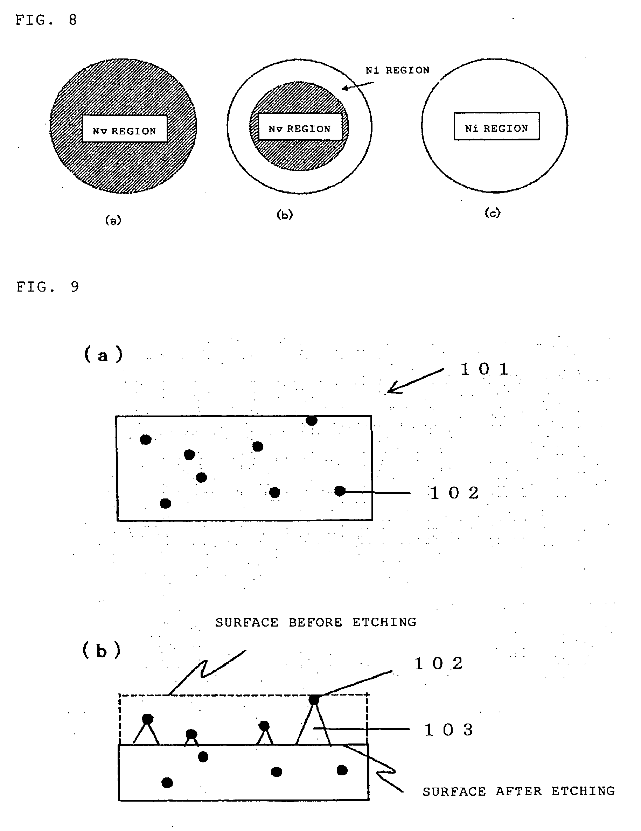

FIG. 7 and FIG. 8 are an explanatory view showing the relationship between a pulling rate and a defect region of the silicon single crystal ingot grown by the CZ method, and an explanatory view showing defect distribution in a plane of the silicon single crystal wafer sliced from the silicon single crystal ingot respectively, which are described in Patent Literature 1 already suggested by the present inventors.

FIG. 7 is an example where a pulling rate (hereinafter, also referred to as a growth rate) V (mm/min) when growing the single crystal is varied to change V/G as a ratio of the pulling rate to an average value G (°C/mm) of an in-crystal temperature gradient in a pulling axis direction in a temperature range from a silicon melting point to 1300°C.
It is generally known that temperature distribution in the single crystal is dependent on a structure in a CZ furnace (hereinafter referred to as a hot zone (HZ)), and that the distribution hardly changes even when the pulling rate is varied. In case of the CZ furnace having the same structure, therefore, V/G is associated with a change in the pulling rate alone. That is, the pulling rate V and V/G approximately have a direct proportion relationship. Therefore, the pulling rate V is used for an ordinate in FIG. 7.

In a region where the pulling rate V is relatively high, grown-in defects, such as FPD, LSTD, and COP, considered as voids formed as a result of agglomeration of point detects called the above-described vacancies, exist at a high density in an approximately entire region in a crystal radial direction, and a region where these defects exist is called a V-Rich region.
When the pulling rate is further decreased, an OSF ring produced in a crystal periphery shrinks toward a crystal center, and are finally annihilated.

When the pulling rate is decreased further than that, there appears a Neutral (hereinafter referred to as N) region where excess or deficiency of Va or Interstitial Silicon rarely occurs. It has been revealed that there is bias between Va and I in the N region, but they do not become agglomerated defects since this N region has Va and I of a saturated concentration or less.
The N region is classified into an Nv region where Va is dominant and an Ni region where I is dominant. It has been known that when a thermal oxidation treatment is performed, a large amount of oxide precipitates (Bulk Micro Defect, hereinafter referred to as BMD) are generated in the Nv region, and few oxide precipitates are generated in the Ni region.

When the pulling rate V is further decreased, I becomes supersaturated, defects of L/D (Large Dislocation: an abbreviation of an interstitial dislocation loop, such as LSEPD and LEPD) considered as a dislocation loop formed by agglomeration of I are consequently produced at a low density, and this region is called an I-Rich region.

The single crystal is accordingly pulled up while controlling the growth rate in a range where the N region can be formed over the entire region in a radial direction from the center of the crystal, and is sliced and polished. As a result, a wafer in which the entire plane thereof is the N region and extremely few defects exist can be obtained.

For example, a wafer sliced out at a position A-A in FIG. 7 becomes a wafer having the Nv region in the entire plane as shown in FIG. 8(a). FIG. 8(b) shows a wafer sliced out at a position B-B in FIG. 7, and the Nv region exists at a wafer central portion while the Ni region exists at an outer circumferential portion thereof. FIG. 8(c) shows a wafer sliced out at a position C-C in FIG. 7, and a wafer having the Ni region in the entire plane can be obtained.

As described above, it has been revealed that BMDs are hardly generated in the Ni region even when a heat treatment is performed. This BMD adversely affects device characteristics, such as a junction leakage, when it is generated in the wafer surface, which is a device active region. On the other hand, this BMD is effective when it exists in a bulk other than the device active region, since it functions as a gettering site that captures a metal impurity mixed during a device process.

In recent years, as a method for forming the BMDs inside the Ni region where the BMDs are hardy generated, a method of performing RTP (Rapid Thermal Process) processing (hereinafter also referred to as rapidly heating and rapidly cooling processing or rapid thermal annealing) is suggested.
This RTP processing is a heat treatment method **characterized in that** an Si wafer is rapidly heated from a room temperature at a temperature-increasing rate of, for example, 50°C/s under a nitride formation atmosphere, such as N₂ and NH₃, or a mixed gas atmosphere obtained by mixing such a gas with a nitride non-formation atmosphere, such as Ar or H₂, the Si wafer is kept and heated at a temperature of approximately 1200°C for several dozen seconds, and it is rapidly cooled at a temperature-decreasing rate of, for example, 50°C/s.

A mechanism of forming the BMDs by performing an oxygen precipitation heat treatment after the RTP processing is described in detail in Patent Literature 2 and Patent Literature 3.
Here, the mechanism of forming the BMDs will be briefly explained.
First, in the RTP processing, injection of Va occurs from the wafer surface, for example, during keeping a high temperature of 1200°C under an N₂ atmosphere, and redistribution of Va due to diffusion and annihilation with I occur while cooling the temperature at a temperature-decreasing rate of, for example, 5°C/s between a temperature range of 1200°C and 700°C.
As a result, the Va is unevenly distributed in the bulk. When a heat treatment is performed on the wafer in such a state at, for example, 800°C, oxygen is rapidly clustered in a region having a high Va concentration, and oxygen is not clustered in a region having a low Va concentration.

When a succeeding heat treatment is performed at, for example, 1000°C for a certain period of time in this state, the oxygen clustered grows to form the BMD.
As described above, when the oxygen precipitation heat treatment is performed on the Si wafer subjected to the RTP processing, the BMDs having distribution in a wafer depth direction are formed according to a concentration profile of Va formed in the RTP processing. A desired concentration profile of Va can be therefore formed to the Si wafer by performing the RTP processing while controlling conditions of the atmosphere, maximum temperature, keeping time, and the like. The Si wafer having a desired DZ width and a desired BMD profile in the depth direction can be thereafter produced by performing the oxygen precipitation heat treatment on the obtained Si wafer.

Moreover, Patent Literature 4 discloses that an oxide film is formed on the surface by performing the RTP processing under an oxygen gas atmosphere, and the formation of BMDs are suppressed due to an injection of I from an oxide film interface. As describe in the disclosure, the RTP processing enables the formation of BMDs to be promoted and, on the contrary, to be suppressed according to conditions of an atmosphere gas, a maximum keeping temperature, and the like.
Moreover, since the RTP processing is annealing for an extremely short time, the outward diffusion of oxygen rarely occurs, and the decrease in the oxygen concentration of the surface layer can be almost disregarded.

On the other hand, it has been also reported that the grown-in defects, such as COPs and OSF nucleuses, are annihilated by the RTP processing. For example, Patent Literature 5 discloses that a wafer of the V-rich region having COPs is subjected to the RTP processing at a temperature of 1200°C or more under a hydrogen gas atmosphere to annihilate the COPs, thereby the DZ layer is formed on the surface layer, and the TZDB characteristic, which is one of oxide film reliability, and a TDDB (Time Dependent Dielectric Breakdown) characteristic, which is long-term reliability and a time dependent breakdown characteristic, are improved.

However, when oxidization treatment is performed at 1050°C for 30 minutes after the RTP processing, both of the TZDB and TDDB characteristics are decreased by approximately 15 to 20%. This means that, when a very shallow portion of the surface layer is removed by removing the oxide film formed by the oxidization treatment at 1050°C for 30 minutes, the COPs are not completely annihilated, although the COPs on the surface are annihilated after the RTP processing, and that the COPs of the whole device active region cannot be annihilated.

Moreover, Patent Literature 6 discloses that the TZDB characteristic is improved by performing the RTP processing on a wafer in which the OSF region and N region exist together, at a temperature of 1135°C or more in a hydrogen gas. The TDDB characteristic, however, has not been examined.

The TZDB characteristic is used for evaluating field intensity at which a breakdown of the oxide film occurs at the moment when an electric field is applied to the oxide film, and is used for evaluating a so-called initial breakdown.
In recent devices, as typified by a flash memory, the long-term reliability of the oxide film, namely the TDDB characteristic, is important.

In addition, in a large majority of recent devices, for device isolation, there has been adopted a method of forming a shallow groove called Shallow Trench Isolation (hereinafter referred to as STI) to separate devices. The STI is basically formed by the same apparatus and principle as the RIE (Reactive Ion Etching) method.

Here, a method for evaluating a crystal defect by using the RIE method will be explained in advance.
The RIE method is a method for evaluating a micro crystal defect containing silicon oxide (hereinafter referred to as SiOx) in a semiconductor single crystal substrate while providing resolving power in a depth direction and a method disclosed in Patent Literature 7 is known. This method performs high-selective anisotropic etching, such as reactive ion etching, by a predetermined thickness on a main surface of a substrate, and performs an evaluation of a crystal defect by detecting the remaining etching residue.

Since a region where a crystal defect containing SiOx is formed and a region where SiOx is not contained have different etching rates from one another (the etching rate of the former is lower than that of the latter), when the above-described etching is performed, a conical hillock having a crystal defect containing SiOx as a vertex remains on the main surface of the substrate. The crystal defect becomes evident in the form of a projection portion by the anisotropic etching, and it makes possible to readily detect even a minute defect.

Hereinafter, the method for evaluating a crystal defect by using the RIE method disclosed in Patent Literature 7 will be explained with reference to FIG. 9.
First, as shown in FIG. 9(a), oxide precipitates (BMDs 102), which is, as SiOx, precipitation of oxygen dissolved in a supersaturated status in the silicon wafer 101 by heat treatment, are formed. With a commercial RIE apparatus, the silicon wafer 101 is etched from the main surface thereof under an atmosphere of a halogen-based mixed gas (for example, HBr/Cl₂/He+O₂) by the anisotropic etching that has a high selection ratio against the BMDs 102 contained in the silicon wafer 101. Then, as shown in FIG. 9(b), conical projections caused by the BMDs 102 are formed as etching residues (hillocks 103). On the basis of the hillocks 103, it is therefore possible to evaluate the crystal defect.
For example, by counting the number of hillocks 103 thus obtained, it is possible to obtain the density of BMDs in the silicon wafer 101 at an etched area.
A detectable defect by the RIE method is a defect relevant to oxide precipitate, the grown-in defect, such as COP and OSF, which is a complex defect as a result of agglomeration of vacancy and oxygen, and a grown-in oxide precipitate as a result of agglomeration of oxygen alone.

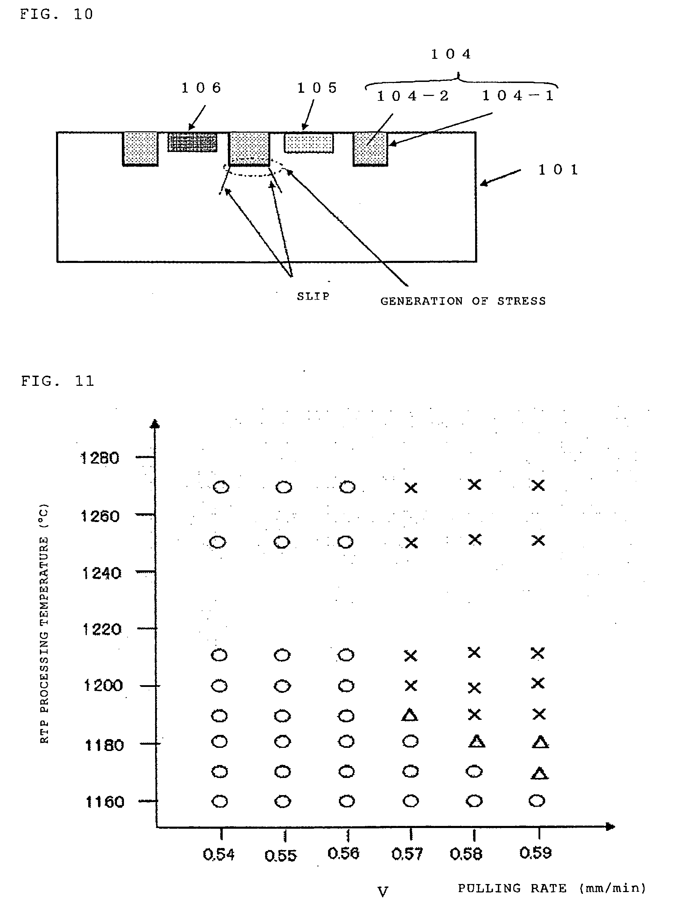

FIG. 10 is a schematic view showing the cross section of STI. The shallow grooves 104-1 are formed on the surface of the silicon wafer 101 by etching of the oxide film and silicon with the RIE apparatus. The STIs 104 are formed by burying SiO₂ 104-2 by CVD (Chemical Vapor Deposition). Devices are to be formed between the STIs 104.
In normal devices, an N-channel MOS transistor 105 and a P-channel MOS transistor 106 are formed, and these are separated by the STIs 104.

Since the SiO₂ 104-2, which has larger volume than that of Si, is buried inside the STIs 104, tensile stress is generally generated at an interface between the STIs 104 and silicon, and there therefore arises a problem that the deformation of the silicon wafer and slip dislocations are generated by the stress. The stress is most remarkably generated at the bottom of each of the STIs 104.
The wafer strength of the surface layer in which the STI is to be formed is thus important.

Incidentally, when oxide precipitates exist in the STI-formed region, there arises a problem that the hillocks are formed inside the groove during the formation of the groove of STI with the RIE apparatus (See Non Patent Literature 1).
It is therefore necessary that there exist no defects relevant to oxygen, such as the oxide precipitates, COPs, and OSF nucleuses, at least in the region where the STI is to be formed. Moreover, it has been known the following. When a MOS transistor is fabricated in a device process and reverse bias is applied to a gate electrode for its operation, a depletion layer expands. The existence of the BMDs in this depletion layer region causes a junction leakage.
Judging from the above-described matters comprehensively, it is necessary that there do not exist the grown-in defects, such as the COPs and OSF nucleuses, and the RIE defects, which are the grown-in oxide precipitates, in the region having a certain depth (up to a depth of 1 µm in the latest devices) from the surface of a device operation region. A depth of 3 µm is more preferably required.

Generally, an oxygen concentration of a solid solubility limit or less is required for the annihilation of defects relevant to oxygen, such as the COPs, OSF nucleuses, oxide precipitates. This can be achieved by using a method of making it the solid solubility limit or less by performing a heat treatment at, for example, 1100°C or more and utilizing outward the diffusion of oxygen to decrease the oxygen concentration of the surface layer. However, there arises a problem that the oxygen concentration of the surface layer is remarkably decreased due to the outward diffusion of oxygen, and therefore the mechanical strength of the surface layer is also decreased.

### CITATION LIST

### PATENT LITERATURE

Patent Literature 1:Japanese Unexamined Patent publication (Kokai) No.2007-191320
Patent Literature 2:Japanese Unexamined Patent publication (Kokai) No.2001-203210
Patent Literature 3:Japanese Translation of PCT International Application publication (Kokai) No.2001-503009
Patent Literature 4:Japanese Unexamined Patent publication (Kokai) No.2003-297839
Patent Literature 5:Japanese Unexamined Patent publication (Kokai) No.H10-326790
Patent Literature 6:Japanese Unexamined Patent publication (Kokai) No.2003-224130
Patent Literature 7:Japanese Unexamined Patent publication (Kokai) No.2000-58509

### NON PATENT LITERATURE

Non Patent Literature 1:T. Hayakawa etc, JPN J Appl Phys Vol37 (1998) pp5-9

### SUMMARY OF INVENTION

The present invention was accomplished in view of the above-explained problems, and its object is to provide a wafer in which the strength of the surface layer thereof is sufficiently ensured without a decrease in oxygen concentration of the surface layer due to outward diffusion as much as possible, the RIE defects, such as oxide precipitates, COPs, and OSFs, do not exist, and the TDDB characteristic is superior.

To achieve this object, the present invention provides an annealed wafer obtained by performing rapid thermal annealing on a silicon single crystal wafer sliced from a silicon single crystal ingot in which an entire plane is an OSF region, an N region outside an OSF region, or a mixed region thereof, the silicon single crystal ingot being grown by the Czochralski method, wherein RIE defects do not exist in a region having at least a depth of 1 µm from a wafer surface, a good chip yield of a TDDB characteristic is 80% or more, and a depth of a region where an oxygen concentration is decreased due to outward diffusion of the surface is within 3 µm from the wafer surface.

In this manner, in the first place, the annealed wafer is obtained by performing rapid thermal annealing on the silicon single crystal wafer sliced from the silicon single crystal ingot in which an entire plane is an OSF region, an N region outside an OSF region, or a mixed region thereof by the CZ method, and the RIE defects do not exist in the region having at least a depth of 1 µm from a wafer surface. Therefore, hillocks are not formed during forming the groove of the STI with the RIE apparatus in a device process, for example, for fabricating latest devices, and the like, and a flat and fine-shaped groove can be formed. It is to be noted that the OSF nucleuses also do not exist as understood by nonexistence of the RIE defects.
In addition, the deterioration of the TDDB characteristic can be suppressed, the good chip yield of the TDDB characteristic is 80% or more, and a superior wafer can be thus obtained. It is to be noted that the good chip yield of the TDDB characteristic described herein means the good chip yield of γ mode, which is an intrinsic failure mode.

Furthermore, since the depth of the region where the oxygen concentration is decreased due to the outward diffusion of the surface is within 3 µm from the wafer surface, a wafer in which the oxygen concentration and strength thereof are not decreased in the surface layer can be readily obtained at low cost, for example, by polishing the surface very slightly. The wafer can endure the stress generated at the bottom of the STI in the fabrication of devices, because of no decrease in strength, and thereby the slip dislocations can be suppressed.

In this case, the oxygen concentration of the annealed wafer can be uniform in a region having a depth deeper than that of 3 µm from the wafer surface.
Since the depth of the region where the oxygen concentration is decreased due to the outward diffusion is within 3 µm from the wafer surface and the rapid thermal annealing is performed, an amount of decrease in the oxygen concentration of the surface layer is small, oxygen taken in during the pulling by the CZ method spreads uniformly in the region having a depth deeper than that depth, and thereby the annealed wafer can be obtained in which an amount of decrease in the strength is extremely small.

Moreover, the silicon single crystal wafer to be subjected to the rapid thermal annealing can be sliced from a silicon single crystal ingot in which an entire plane is an Nv region, an Ni region, a mixed region thereof, or a mixed region of the OSF region and the Nv region.
The region where the entire plane is the Nv region, the Ni region, the mixed region thereof does not include the OSF region, that is, hardly includes the OSF nucleuses, which are the grown-in defects. The annealed wafer according to the present invention can be more surely made to be a wafer where the RIE defects do not exist. In addition, a superior TDDB characteristic can be achieved, and the present invention is thus particularly useful.
Moreover, even when the wafer includes a region containing the OSF region, such as the mixed region of the OSF region and the Nv region, the OSF nucleuses are annihilated, and thereby the annealed wafer can be made to be a wafer in which the oxide precipitates and defects relevant to oxygen do not exist on the surface layer.

Moreover, the wafer can be made so that the RIE defects do not exist in a region having at least a depth of 5 µm from the wafer surface.
In this wafer, the region where the RIE defects do not exist has a deeper depth, more surely the hillocks are not formed on a device region, and a flat and fine-shaped groove can be formed.

Moreover, the depth of the region where the oxygen concentration can be decreased due to the outward diffusion of the surface is within 2 µm from the wafer surface.
With this wafer, a wafer in which the oxygen concentration and strength thereof are not decreased on the surface layer can be more readily obtained at lower cost.

In this case, the oxygen concentration of the annealed wafer can be uniform in a region having a depth deeper than that of 2 µm from the wafer surface.
With this wafer, since the oxygen concentration is uniform from a shallower region, the annealed wafer can be made to be a wafer in which an amount of decrease in the strength is yet smaller.

Furthermore, the present invention provides a method for producing an annealed wafer, including the steps of growing a silicon single crystal ingot by the Czochralski method, and performing rapid thermal annealing on a silicon single crystal wafer sliced from the silicon single crystal ingot, comprising growing the silicon single crystal ingot while controlling a pulling rate in such a manner that an entire plane becomes an OSF region, an N region outside an OSF region, or a mixed region thereof, performing, on the silicon single crystal wafer sliced from the grown silicon single crystal ingot, the rapid thermal annealing at a temperature from more than 1300°C to 1400°C or less for 1 to 60 seconds with a rapidly heating and rapidly cooling apparatus, and thereby producing the annealed wafer in which RIE defects are annihilated from a region having at least a depth of 1 µm from a wafer surface.

In this manner, when the silicon single crystal ingot of the region where the entire plane becomes the OSF region, the N region outside an OSF region, or the mixed region thereof is grown, and the RTP processing at a temperature from more than 1300°C to 1400°C or less for 1 to 60 seconds is performed on the silicon single crystal wafer sliced from the silicon single crystal ingot, the annealed wafer in which the RIE defects are annihilated from the region having at least a depth of 1 µm from the wafer surface can be produced. That is, the OSF nucleus of the grown-in defects generated in the OSF region and the grown-in oxide precipitate nuclei generated particularly in the Nv region can be annihilated. The annealed wafer in which the oxide precipitates and defects relevant to oxygen do not exist on the surface layer can be consequently obtained.
Therefore, hillocks are not formed during forming the groove of the STI in the fabrication of latest devices and the like, and a flat and fine-shaped groove can be formed.
In addition, the annealed wafer having a good TDDB characteristic can be obtained.

Furthermore, because of the RTP processing, the region where the oxygen concentration is decreased due to the outward diffusion of the surface can be made to locate in an extremely shallow range of within 3 µm from the surface, a wafer in which the oxygen concentration and strength thereof are not decreased on the surface layer can be readily obtained at low cost, for example, by polishing the surface very slightly. The annealed wafer can thereby endure the stress generated at the bottom of the STI in the fabrication of device, and thereby the slip dislocations can be suppressed.
Moreover, the RTP processing is sufficiently performed for 1 to 60 seconds. In particular, when the upper limit is 60 seconds, increasing cost due to a decrease in productivity and easily generating the slip dislocations during the heat treatment can be prevented. In addition, a large amount of decrease in the oxygen concentration in the surface layer due to the outward diffusion of oxygen becoming large during the heat treatment can be prevented, and the mechanical strength can be prevented from decreasing.

In this case, the silicon single crystal wafer to be subjected to the rapid thermal annealing can be sliced from a silicon single crystal ingot in which an entire plane is an Nv region, an Ni region, or a mixed region thereof.
By this method, since the OSF nucleuses do not exist in the wafer subjected to the rapid thermal annealing, the rapid thermal annealing needs only to dissolve the grown-in oxide precipitates present in the N region, particularly the Nv region, and the annealed wafer where the RIE defects do not exist can be more surely obtained. In addition, the annealed wafer having a superior TDDB characteristic can be obtained.
In addition to this, the annealed wafer without the RIE defects can be produced by the rapid thermal annealing for a shorter time, and the present invention is thus particularly useful.

Alternatively, the silicon single crystal wafer to be subjected to the rapid thermal annealing can be sliced from a silicon single crystal ingot in which an entire plane is an OSF region, a mixed region of the OSF region and the Nv region, or a mixed region of the OSF region and the N region, and the rapid thermal annealing can be performed for 10 to 60 seconds.
In this manner, even when it includes the OSF region, the OSF nucleus of the grown-in defects generated in the OSF region can be annihilated, and thereby the annealed wafer in which the oxide precipitates and defects relevant to oxygen do not exist on the surface layer can be obtained. Therefore, a fine-shaped groove can be formed during forming the groove of the STI, and a better TDDB characteristic can be obtained.

Moreover, the RIE defects can be annihilated from a region having at least a depth of 5 µm from the wafer surface by subjecting to the rapid thermal annealing.
By this method, the region where the RIE defects do not exist can be made to have a deeper depth, more surely the hillocks are not formed on a device region, and a flat and fine-shaped groove can be formed.

Moreover, the annealed wafer can be produced in such a manner that a depth of a region where an oxygen concentration is decreased due to outward diffusion of the surface is within 3 µm from the wafer surface.
With this wafer, as described above, a wafer in which the oxygen concentration and strength thereof are not decreased on the surface layer can be readily obtained at low cost, for example, by polishing the surface very slightly. The wafer can therefore endure the stress generated at the bottom of the STI in the fabrication of devices, and thereby the slip dislocations can be suppressed.

Moreover, the annealed wafer can be produced in such a manner that a depth of a region where an oxygen concentration is decreased due to outward diffusion of the surface is within 2 µm from the wafer surface.
In this manner, the depth of the region where the oxygen concentration is decreased due to the RTP processing, specifically the outward diffusion of the surface, is suppressed to a narrower range of within 2 µm from the wafer surface, the decrease in the strength of the surface layer can be limited to a very slight range.

Moreover, the silicon single crystal wafer to be subjected to the rapid thermal annealing preferably has an oxygen concentration of not lower than 4×10¹⁷ and not higher than 9×10¹⁷ atoms/cm³ (JEIDA).
When the oxygen concentration is not lower than 4×10¹⁷ atoms/cm³ (JEIDA), the wafer strength can be more effectively prevented from decreasing.
On the other hand, when the oxygen concentration is not higher than 9×10¹⁷ atoms/cm³ (JEIDA), the size of the grown-in defects and the grown-in oxide precipitates can be prevented from becoming too large, an excessive high temperature and an excessive long time are not necessary for conditions of the rapid thermal annealing, and the method is thus advantageous industrial production-wise. When the oxygen concentration is high, the degree of supersaturation is also high, and the RIE defects are formed by forming the BMDs due to re-precipitation of oxygen during a heat treatment in a device process. In this case, difficulty of making the width of the DZ layer without the BMDs, namely the RIE defects, deeper than that of the device operation region can be prevented.

Moreover, the silicon single crystal wafer to be subjected to the rapid thermal annealing can have a nitrogen concentration of between 1×10¹¹ and 1×10¹⁵ atoms/cm³ and/or have a carbon concentration of between 1×10¹⁶ and 1×10¹⁷ atoms/cm³.
When the wafer has nitrogen with the above-described concentration range, the wafer strength can be more improved. In addition, the formation of the BMDs is accelerated in a bulk portion, and the wafer is advantageous for necessity of high density BMDs.

In addition, in case of a heat treatment at a low temperature (for example, 400 to 600°C) for a long time in a device process, the formation of oxygen donor generated during the heat treatment is suppressed by containing carbon with the above-described concentration range (Realize Corp. "Science in Silicon" supervised by Oumi, Nitta p542).
Here, the oxygen donor will be briefly explained. The oxygen donor, which is a compound consisting of 3 to 6 atoms of oxygen during heat treatment, is formed, and two free electrons are supplied into silicon. This changes the resistivity of silicon and a threshold value Vth of a MOS transistor.
Moreover, it has been known that carbon enhances the BMDs by a heat treatment at 500 to 800°C and is advantageous for necessity of high density BMDs in the bulk portion.

Furthermore, the present invention provides a method for fabricating a device, wherein, when the device is fabricated by using the annealed wafer produced by the above-described method for producing an annealed wafer, dry etching is performed. In this case, the device is preferably an image pickup device.

The annealed wafer produced by the method for producing an annealed wafer according to the present invention is used as a material of devices requiring a process of etching by dry etching processing, which is typified by the STI, and the hillocks can be thereby prevented from being formed during etching due to the defects relevant to oxygen and oxide precipitates. As a result, it can be etched uniformly.

Generally, it has been known that a wafer radial distribution of the BMDs is generated in a multiple ring shape along striation of oxygen generated during the crystal growth with a width of approximately 100 µm and with light and shade (Realize Corp. "Science in Silicon" supervised by Oumi, Nitta p128), and that characteristics of a CCD and CMOS image sensor is affected by the light and shade of the BMDs. It is desirable that light and shade are as uniform as possible.

In the annealed wafer according to the present invention, the grown-in oxide precipitates are completely dissolved and annihilated by the RTP processing once, and a thermal history subjected during the crystal growth is thereby reset completely. In addition, it uses a region where the grown-in oxide precipitates are hardly generated, and thereby the contrast of light and shade of the BMDs generated by a heat treatment in a device process becomes lighter than a first striation pattern.

Moreover, the BMDs are generated uniformly over the whole wafer due to the vacancies uniformly introduced in a plane of the bulk during the RTP processing, in addition to the resetting of the thermal history during the crystal growth completely.
This effect enables the variation in a plane of characteristics of the CCD and CMOS image sensor to be made small.

As described above, according to the present invention, since the grown-in oxide precipitates and grown-in defects relevant to oxygen, such as COPs and OSFs, do not exist on the surface layer, which is the device operation region, the annealed wafer having a good TDDB characteristic can be provided. In addition, when the annealed wafer obtained by the present invention as a material is etched by the dry etching processing in a device process, harmful hillocks are not generated, and the etching can be therefore performed uniformly and with high quality.
Moreover, the amount of decrease in the oxygen concentration is small and it is an extremely narrow region in this surface layer. A wafer in which the strength is not decreased can be therefore provided readily at low cost.

### BRIEF DESCRIPTION OF THE DRAWINGS

FIG. 1 is a schematic view showing an example of the annealed wafer according to the present invention;
FIG. 2 is an explanatory view showing an example of the steps of the method for producing an annealed wafer according to the present invention;
FIG. 3 is a schematic view showing an example of a single crystal pulling apparatus;
FIG. 4 is an explanatory view showing the relationship between the growth rate and each defect distribution of a silicon single crystal ingot, obtained by a preliminary examination;
FIG. 5 is a schematic view showing an example of a rapidly heating and rapidly cooling apparatus;
FIG. 6 is a graph showing oxygen concentration profiles in Example 10 and Comparative Example 9;
FIG. 7 is an explanatory view showing the relationship between the defect regions and the pulling rate of a silicon single crystal ingot grown by the CZ method;
FIGS. 8 are explanatory views showing a radial defect distribution of a silicon single crystal wafer sliced from a silicon single crystal ingot, in which (a) shows a case where the entire plane is the Nv region, (b) shows a case where a wafer central portion is the Nv region, and a wafer outer circumference portion is the Ni region, and (c) a case where the entire plane is the Ni region;
FIGS. 9 are explanatory views showing an outline of an evaluation method of crystal defects by using the RIE method, in which (a) shows a silicon wafer having oxide precipitates formed thereon, prior to etching, and (b) shows a silicon wafer having hillocks formed thereon due to oxide precipitates, after etching;
FIG. 10 is a schematic view showing an example of the STIs; and
FIG. 11 is an explanatory view showing the relationship of the result of evaluating the pulling rate V of a silicon single crystal, the temperature of the RTP processing on a silicon single crystal wafer obtained from the pulled silicon single crystal, and the TDDB characteristic of the wafer subjected to the RTP processing.

### DESCRIPTION OF EMBODIMENTS

Hereinafter, an embodiment of the present invention will be explained in detail with reference to the drawings, but the present invention is not restricted thereto.
The wafer in which the grown-in defects relevant to oxygen and the grown-in oxide precipitates do not exist in the device operation region, the decrease in the TDDB characteristic is suppressed, and the oxygen concentration is not decreased is useful for recent devices.
In view of this, the present inventors examined a conventional art, and keenly studied on the relationship among the RTP processing, TDDB characteristic, RIE defects, and oxygen concentration of the wafer surface layer to obtain the above-described wafer.

First, the above-described Patent Literature 2 describes a method of slicing an Si wafer from the N region of single crystal, in which agglomeration of Va and I does not exist, and performing the RTP processing on the wafer in which the wafer entire plane is the N region.
In case of this method, since the grown-in defects do not exist in the silicon wafer to be a material, it can be considered that there is no problems for performing the RTP processing. However, when the TDDB characteristic, which is long-term reliability of an oxide film and a time dependent breakdown characteristic, is measured after preparing the silicon wafer in which the entire plane is the N region and performing the RTP processing, the TZDB characteristic is hardly decreased in the Nv region of the wafer, whereas the TDDB characteristic is decreased in some cases (Patent Literature 1).

FIG. 11 is an explanatory view showing the relationship of the pulling rate V of a silicon single crystal, the temperature of the RTP processing on a silicon single crystal wafer obtained from the pulled silicon single crystal, and the result (O:good,A:somewhat decreased, ×:decreased) of evaluating the TDDB characteristic of the wafer after the RTP processing, which is described in Patent Literature 1.
Hereinafter, it will be briefly explained. In case of a pulling rate V of 0.56 mm/min or less, that is, in the event that the wafer entire plane is the Ni region, when the wafer is subjected to the RTP processing and the TDDB characteristic thereof is thereafter evaluated, the TDDB characteristic is good independently of the temperature of the RTP processing.

In the case of the wafer sliced from the silicon single crystal ingot pulled at a rate of 0.57 mm/min, however, it can be seen that the good chip yield of γ mode, which is an intrinsic failure mode of the oxide film, is decreased in the range of a temperature of 1190°C or more of the RTP processing, and it is still decreased at 1270°C.
The wafer corresponds to a wafer described in FIG. 8(b), and is a wafer in which the Nv region exists in the wafer center and the Ni region exists in the outer circumference portion thereof.

Here, the result of the experiment conducted by the present inventors is that the TDDB characteristic is decreased by the RTP processing. On the other hand, the result disclosed in Patent Literature 5 is that both of the TZDB characteristic and TDDB characteristic are improved by the RTP processing at a temperature of 1200°C or more. These results are considered to be contradiction.

The difference between Patent Literature 1 and Patent Literature 5 is as follows. In Patent Literature 1, a wafer having a mixed region of the Nv region and Ni region is used to perform the RTP processing under an atmosphere of a mixed gas of NH₃ and Ar gases. On the other hand, in the experiment disclosed in Patent Literature 5, the RTP processing is performed in a hydrogen gas on a wafer of the V-Rich region, in which the COPs, which are the grown-in defects formed as a result of agglomeration of the vacancies of point detects, are generated, and the TDDB characteristic is thereafter evaluated.

Patent Literature 2 discloses that the RTP processing under a hydrogen gas atmosphere has a high COP resolvability in comparison with the RTP processing under an atmosphere of Ar gas or a mixed gas of Ar and N₂ gases.
Moreover, in Patent Literature 5, there is also reported that the TZDB and TDDB characteristics are decreased by approximately 15 to 20% by the oxidization treatment at 1050°C for 30 minutes after the RTP processing.

Judging from the above-described matters, in Patent Literature 5, the COPs on the surface or in an extremely shallow region from the surface are annihilated by the RTP processing under a H₂ gas atmosphere, and the TDDB characteristic is thereby recovered. When the oxidization treatment is performed at 1050°C for 30 minutes after the RTP processing, an very thin oxide film is formed, the oxide film is thereafter removed, and the extremely shallow region of the surface layer is removed, the TDDB characteristic is decreased. That is, the COPs located at a position of the depth corresponding to the thickness of the removed oxide film cannot be resolved completely.

As reported in Japanese Unexamined Patent publication (Kokai) No.2009-249205 by the present inventors, the Nv region has a region where the grown-in oxide precipitates exist, namely, a region where the RIE defects exist. In the experiment of Patent Literature 1, the RTP processing is performed at a temperature of 1270°C or less under an atmosphere of a mixed gas of NH₃ and Ar, which has inferior defect resolvability to an H₂ gas. It can be considered that since the grown-in oxide precipitates present in the Nv region are not resolved completely at this temperature range, the TDDB characteristic is decreased.
As explained above, it can be understood that there is no contradiction between Patent Literature 1 and Patent Literature 5.

Moreover, Patent Literature 6 discloses in Example that the TZDB characteristic is improved by performing, on the wafer in which the OSF region and N region exist together, the RTP processing at a temperature of approximately 1135°C in a hydrogen gas.
In addition, it can be understood that there exist no defects that decrease the TZDB characteristic within at least 200 nm from the surface, considering that the TZDB characteristic is not decreased even when the oxidization treatment with 200 nm is performed after the RTP processing.

The TDDB characteristic, however, has not been evaluated which is decreased by substances having a smaller size than that of the defects and oxide precipitates that affect the TZDB characteristic. It is therefore not certain whether defects actually exist in this region or not.
It can be analogized by verification of this result and the experiment result of the present invention in Patent Literature 1 that, in Example of Patent Literature 6, defects and oxide precipitates that exist in the whole region up to 1 µm from the surface, which is the device operation region, and particularly up to 3 µm from the surface cannot be annihilated.

The present inventors further investigated on the basis of the above-described consideration, and keenly conducted studies on the cause of the decrease in the TDDB characteristic after the RTP processing by using the RIE method.
As a result, the present inventors found the following. As described in, for example, Japanese Unexamined Patent publication (Kokai) No.2009-249205, the Nv region has the region where the RIE defects exist and the region where the RIE defects do not exist, and the TDDB characteristic is not decreased in the region where the RIE defects do not exist. The region where the TDDB characteristic can be decreased is particularly the Nv region and a region where the defects that can be detected by the RIE method exist.

In addition, the present inventors also found the following. Even when the TDDB characteristic is not decreased, the RIE defects may be detected by the RIE method in some cases. Even when the RIE defects exist, the TDDB characteristic is not decreased in case of a small size of the RIE defects. That is, the method for evaluating a defect by the RIE method has a higher precision of defect detection than the TDDB characteristic.
Since devices hereafter will become finer and high performance, a wafer having the RIE defects has a potential problem in future, even in the event that defects of the wafer is not detected by the currently used TDDB characteristic. It can be therefore considered that the wafer without the RIE defects is required in future. The present inventors keenly conducted studies on the evaluation of the RIE defect on the basis of the above-described insight. As a result, the present inventors found that the RIE defects present in the Nv region are hardly annihilated when the RTP processing is performed at 1270°C or less and that this is the cause of the decrease in the TDDB characteristic. On the other hand, in case of a RTP temperature of 1290°C or more, the RIE defects are rapidly decreased. The RIE defects can be annihilated almost completely by the RTP processing at a higher temperature than 1300°C; and additionally the TDDB characteristic can be improved again. In addition to this, the OSF nucleuses can be also annihilated by the RTP processing at such a high temperature. The TDDB characteristic can be thereby prevented from being deteriorated due to the OSF nucleuses, and the OSF region can be used.

Moreover, because of the RTP processing, the decrease in the oxygen concentration in the wafer surface layer due to the outward diffusion from the surface can be limited to within a region having a very slight depth.
The present inventors found the above-described matters and thereby brought the present invention to completion.

Hereinafter, the annealed wafer according to the present invention will be explained.

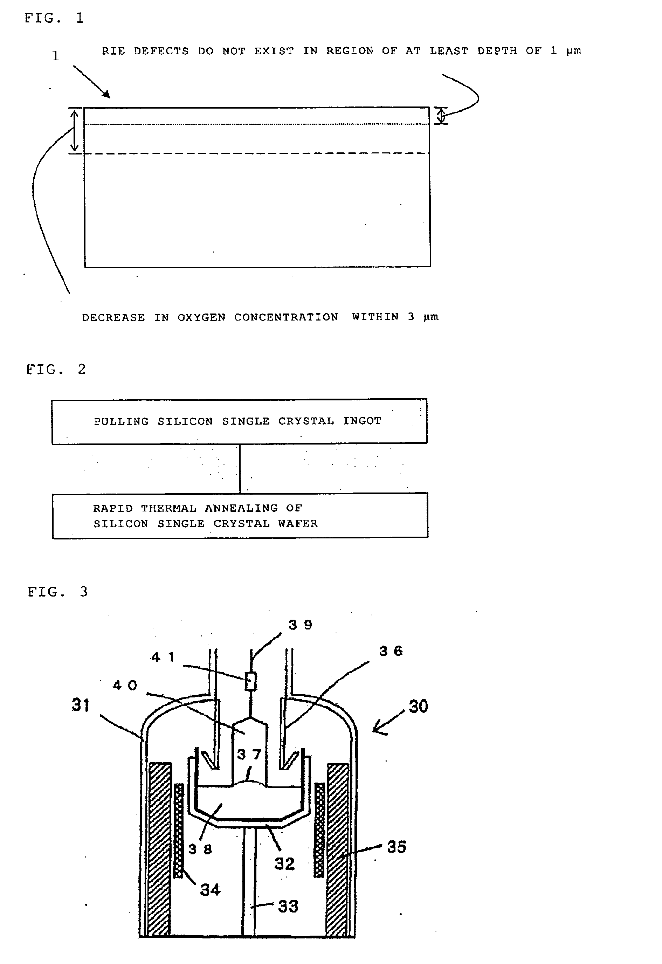

FIG. 1 shows an example of the annealed wafer according to the present invention. The annealed wafer 1 according to the present invention is produced from a silicon single ingot grown by the CZ method. More specifically, the wafer is obtained by performing the RTP processing on a silicon single crystal wafer sliced from the silicon single crystal ingot in which the entire plane is the OSF region, the N region outside an OSF region, or the mixed region thereof.

Since the annealed wafer 1 is subjected to the RTP processing, the region where the oxygen concentration is decreased due to the outward diffusion of the surface is limited to within 3 µm, further 2 µm, or 1 µm from the wafer surface. The concentration of oxygen taken in by the CZ method during the growth is uniform in a region having a depth deeper than that of 3 µm (further, 2 µm) from the wafer surface. Accordingly, in the event that an RIE defect free region has a depth of 1 µm or more from the surface and further 5 µm or more from the surface, the wafer in which the oxygen concentration distribution is uniform in a depth direction and is not decreased in the wafer surface layer and the strength is not decreased can be readily obtained by removing a very slight depth of 1 to 3 µm in the wafer surface layer by polishing and the like, as needed. Since the strength of the wafer is not decreased, it can endure the stress generated at the bottom of the STI in the fabrication of devices, and the slip dislocations can be suppressed.

On the other hand, in case of a wafer subjected to not the RTP process but a heat treatment for a long time, the region where the oxygen concentration is decreased due to the outward diffusion of the wafer surface layer expands relatively deeply. To obtain a wafer without the decrease in strength, therefore, it is necessary to polish thickly up to a deeper region for the expanding region. Thus, cost and work are increased.

In the annealed wafer 1 according to the present invention, the RIE defects do not exist in the region having at least a depth of 1 µm from the wafer surface. In addition, when the TDDB characteristic is measured, the good chip yield of γ mode, which is the intrinsic failure mode of the oxide film, is 80% or more.
The region where the RIE defects do not exist, that is, the region where the defects relevant to oxygen do not exist spreads to a depth range of 1 µm or more. Therefore, the wafer does not have the RIE defects in the region of a depth of 1 µm or more, which is the operation region of the latest devices. Moreover, in the event that the region where the RIE defects relevant to oxygen do not exist has a depth of 5 µm or more, even when the region, in which the oxygen concentration is decreased, within a depth of 3 µm from the wafer surface is removed as described above, the RIE defects do not exist in the region having a depth of 1 µm or more, and therefore the hillocks can be prevented from being formed due to the defects relevant to oxygen during the formation of the groove of the STI with the RIE apparatus in a device process.

Here, the silicon single crystal wafer to be subjected to the rapid thermal annealing can be sliced from a silicon single crystal ingot in which an entire plane is the Nv region, the Ni region, the mixed region thereof. Since these regions hardly include the OSF nucleuses, the annealed wafer can be made to be a wafer in which the RIE defects do not exist more surely than a wafer having the OSF region.
Moreover, also in case of the wafer having the OSF region (for example, a mixed region of the OSF region and Nv region), the OSF nucleuses can be annihilated by the rapid thermal annealing, and the annealed wafer becomes a wafer in which the RIE defects do not exist in the surface layer.

Next, the method for producing an annealed wafer according to the present invention, which can produce the above-described annealed wafer according to the present invention will be explained.
As shown in FIG. 2, in the present invention, first, a silicon single crystal ingot is grown while controlling the pulling rate in such a manner that the entire plane becomes the OSF region, the N region outside an OSF region, or the mixed region thereof. Next, the silicon single crystal wafer is sliced from the ingot. The obtained wafer is a wafer in which the entire plane is the OSF region, the N region outside an OSF region, or the mixed region thereof. The rapid thermal annealing is performed on the silicon single crystal wafer at a temperature from more than 1300°C to 1400°C or less for 1 to 60 seconds, and thereby the annealed wafer is produced.
The RIE defects are annihilated from the region having at least a depth of 1 µm from the wafer surface by the above-described steps.

It is to be noted that the diameter of the silicon single crystal ingot to be grown is not restricted in particular. For example, the diameter may be 150 to 300 mm or more, and the ingot having a desired diameter can be grown according to use.
With regard to the defect region of the silicon single crystal ingot to be grown, as described above, the ingot may be grown in such a manner that an entire plane becomes the OSF region, the N region outside an OSF region, or the mixed region thereof. Even when the ingot includes the OSF region, the OSF nucleuses can be annihilated by high temperature RTP processing to be later performed, and the annealed wafer can be produced in which the RIE defects do not exist in a region having a sufficient depth from the wafer surface. In addition, when the ingot having the Nv region is grown, it is particularly useful for preventing the decrease in the good chip yield of the TDDB characteristic.

First, a single crystal pulling apparatus that enables the producing method according to the present invention to be carried out will be explained. FIG. 3 shows the single crystal pulling apparatus 30. The single crystal pulling apparatus 30 is configured to include a pulling chamber 31, a crucible 32 provided in the pulling chamber 31, a heater 34 arranged around the crucible 32, a crucible holding shaft 33 for rotating the crucible 32, a rotating mechanism thereof (not shown), a seed chuck 41 for holding a silicon seed crystal, a wire 39 for pulling the seed chuck 41, and a winding mechanism (not shown) for rotating or winding the wire 39. With regard to the crucible 32, a quartz crucible is provided at a side of containing a silicon melt 38 inside the crucible 32, and a graphite crucible is provided outside the crucible 32. A heat-insulating material 35 is arranged around the outside of the heater 34.

According to production conditions, as shown in FIG. 3, an annular graphite cylinder (a gas flow-guide cylinder) 36 and an annular outside heat-insulating material (not shown) at an outer circumference of a solid-liquid interface 37 of crystal can be also provided. Moreover, a cooling gas can be splayed and a cylindrical cooling apparatus for cooling the single crystal by blocking radiant heat can be provided.
Moreover, a magnet, not shown, can be arranged at the outside in horizontal direction of the pulling chamber 31, to use a so-called MCZ method in which the convection of the melt is suppressed by applying a magnetic field horizontally or vertically with respect to the silicon melt 38 to stably grow the single crystal.
For example, each member of the apparatus can be the same as a conventional apparatus.

Hereinafter, an example of a method for producing a single crystal with the above-described single crystal pulling apparatus 30 will be explained.
First, a silicon polycrystalline raw material with high purity is heated to a temperature of a melting point (approximately 1420°C) or more to melt in the crucible 32. Next, the tip of the seed crystal is brought into contact with or dipped into an approximate center portion of the surface of the silicon melt 38 by unreeling the wire 39. The wire 39 is thereafter reeled up with rotating it to pull the seed crystal, while the crucible-holding shaft 33 is rotated in an appropriate direction, and thereby the growth of the silicon single crystal ingot 40 is started.
Hereafter, an approximate cylindrical silicon single crystal 40 is obtained by appropriately adjusting the pulling rate and temperature.

In order to control a desired pulling rate (growth rate) efficiently, for example, a preliminary examination for investigating the relationship between the pulling rate and the defect region is carried out while an ingot is grown with changing the pulling rate. On the basis of the relationship, the silicon single crystal ingot can be afresh produced so as to obtain a desired defect region by controlling the pulling rate, in a main examination.

Hereinafter, the above-described preliminary and main examinations will be explained.
In the preliminary examination, the growth rate was controlled so as to gradually decrease it from the head of crystal to the tail thereof in the range from 0.7 mm/min to 0.4 mm/min during pulling the silicon single crystal ingot. The single crystal was produced so that the oxygen concentration thereof became between 6×10¹⁷ and 7×10¹⁷ atoms/cm³ (JEIDA).

The pulled single crystal ingot was cut longitudinally in a crystal axis direction to produce a plurality of plate-like blocks.
One of the plate-like blocks was cut in a crystal axis direction into pieces having a length of 10 cm. They were subjected to a heat treatment at 650°C for 2 hours under a nitrogen atmosphere in a wafer heat treatment furnace. The temperature was thereafter increased to 800°C and kept for 4 hours. The atmosphere was thereafter switched to an oxygen atmosphere, the temperature was increased to 1000°C and kept for 16 hours, and cooled. Then they were taken out.
X-ray topography images were thereafter shot, and a map of a wafer lifetime was created by WT-85 made by SEMILAB Co., Ltd.
Moreover, regarding a second block, an OSF heat treatment at 1100°C for 1 hour under a wet oxygen atmosphere was performed, and thereafter secco-etching was performed to confirm a status of OSF distribution.

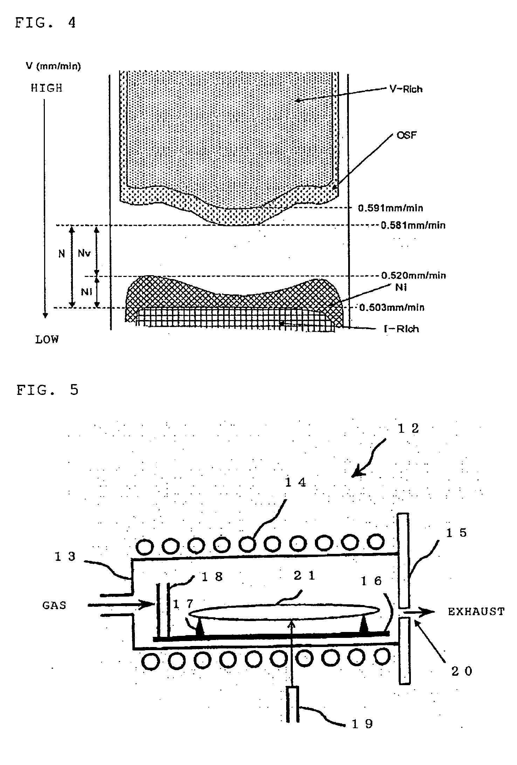

On the basis of the above-described knowledge, the V-Rich region, OSF region, Nv region, Ni region, and I-Rich region were identified each. FIG. 4 shows the growth rate and defect distribution of the silicon single crystal ingot by the preliminary examination.

An example of the growth rate at each boundary of the pulled single crystal will be hereinafter explained.
V-Rich/OSF Region Boundary: 0.591 mm/min
OSF Annihilation Boundary: 0.581 mm/min
Nv/Ni Region Boundary: 0.520 mm/min
Ni/I-Rich Region Boundary: 0.503 mm/min

Here, as the main examination, a silicon single crystal ingot 40 is grown while controlling the pulling rate afresh so as to have a desired defect region, by using the same HZ structure as that by which the defect regions were identified, on the basis of the above-described relationship between the growth rate and defect distribution.

For example, in case of FIG. 4, when the silicon single crystal is grown while controlling the pulling rate V so as to be 0.586 mm/min and cut in a diameter direction, there can be obtained a wafer having a mixed region of the OSF region and Nv region, in which the OSF region exist at the wafer center portion and the Nv region exist at the outer circumference portion thereof (hereinafter, referred to as an OSF plus Nv wafer).
Alternatively, when the silicon single crystal is grown while controlling the pulling rate V so as to be 0.515 mm/min and cut in a diameter direction, there can be obtained a wafer having a mixed region of the Nv region and Ni region, in which the Nv region exist at the center portion thereof and the Ni region exist at the outer circumference portion thereof (hereinafter, referred to as an Nv plus Ni wafer).

Naturally, it is not restricted to these defect regions, the silicon single crystal ingot having a desired defect region in a radial direction can be grown by adjusting the pulling rate, HZ structure and the like.

Moreover, the oxygen concentration of the silicon single crystal ingot to be grown is not restricted in particular. For example, it can be grown so as to have an oxygen concentration of not lower than 4×10¹⁷ and not higher than 9×10¹⁷ atoms/cm³ (JEIDA).
When it is not lower than 4×10¹⁷ atoms/cm³ (JEIDA), the decrease in the wafer strength can be more effectively prevented.
Moreover, when it is not higher than 9×10¹⁷ atoms/cm³ (JEIDA), the size of the grown-in defects and grown-in oxide precipitates can be prevented from becoming too large, an excessive high temperature and an excessive long time are not necessary for conditions of the rapid thermal annealing, and the method is thus advantageous industrial production-wise. When the oxygen concentration is high, the degree of supersaturation is also high, and the RIE defects are thereby formed by the BMDs due to re-precipitation of oxygen during a heat treatment in a device process. In this case, difficulty of making the width of the DZ layer without the BMDs deeper than that of the device operation region can be prevented.

Moreover, according to the purpose, it can be doped with nitrogen. In case of doping with nitrogen, for example it can be doped with nitrogen of a concentration between 1×10¹¹ and 1×10¹⁵ atoms/cm³. This enables the wafer strength to be improved, and the formation of the BMDs to be accelerated in a bulk portion.

Moreover, for example, it can be doped with carbon of a concentration between 1×10¹⁶ and 1×10¹⁷ atoms/cm³. In case of a heat treatment at a low temperature (for example, 400 to 600°C) for a long time in a device process, the formation of oxygen donor generated during the heat treatment can be suppressed. The formation of the BMDs can be accelerated in the bulk portion.

The silicon single crystal ingot having a desired defect region is grown as described above, and the silicon single crystal wafer sliced from the ingot is subjected to the rapid thermal annealing with a rapidly heating and rapidly cooling apparatus. FIG. 5 shows an example of the rapidly heating and rapidly cooling apparatus.
The rapidly heating and rapidly cooling apparatus 12 has a quartz chamber 13, and can perform the rapid thermal annealing on the silicon single crystal wafer 21 in the chamber 13. Heating lamps 14 (for example, halogen lamps) are arranged so as to surround the chamber 13 from the left, right, top, and bottom, and heating is performed by the heating lamps. The heating lamps 14 can control electric power to be supplied separately.

An auto shutter 15 is equipped at a gas exhaust side to blockade the air. The auto shutter 15 is provided with a wafer insert opening, not shown, configured so as to be openable by a gate valve. The auto shutter 15 is also provided with a gas outlet 20, and thereby can adjust an atmosphere in the furnace.
The silicon single crystal wafer 21 is put on a three-point support portion 17 formed on a quartz tray 16. A quartz buffer 18 is arranged at the side of the gas inlet of the tray 16, and thereby the silicon single crystal wafer 21 can be prevented from being directly exposed to an introduced gas, such as an oxidizing gas, a nitriding gas, and an Ar gas.
The chamber 13 is provided with a special window for temperature measurement, not shown, and the temperature of the silicon single crystal wafer 21 can be measured through the special window with a pyrometer 19 arranged outside the chamber 13.
As the rapidly heating and rapidly cooling apparatus 12, a conventional apparatus can be also used.

With the above-described rapidly heating and rapidly cooling apparatus, the silicon single crystal wafer is subjected to the rapid thermal annealing. In this case, when it is performed under an atmosphere of a non-oxidizing gas/non-nitriding gas, such as an Ar gas and a hydrogen gas, or an atmosphere of a nitriding gas, such as an N₂ gas and an NH₃ gas, or an atmosphere of a mixed gas thereof, Va is injected and frozen in the bulk by the RTP processing. Therefore, the BMDs are not formed in the shipment stage of the wafer, and a larger amount of BMDs are obtained in the bulk while the DZ layer without the RIE defects is ensured in the surface layer during a device heat treatment. The wafer having a high gettering capability can be consequently provided.

In addition, when the RTP processing is performed in a gas containing a nitride gas atmosphere, such as an N₂ gas and NH₃ gas, N atoms are introduced into the wafer during the RTP processing, and the wafer strength is advantageously improved.

On the other hand, when the RTP processing is performed under an oxygen gas atmosphere, I is injected and frozen, and the BMDs to be generated during a heat treatment in a device process can be suppressed.
An appropriate gas atmosphere may be used for use.

In this case, heat treatment conditions are as follows. After rapidly heating, the heat treatment is performed at a temperature from more than 1300°C to 1400°C or less for 1 to 60 seconds, followed by rapidly cooling. For example, the temperature is increased at a temperature-increasing rate of 50°C/s, and after performing the above-described heat treatment, the temperature is decreased at a temperature-decreasing rate of 50°C/s. The temperature-increasing rate and temperature-decreasing rate can be appropriately set.

A heat treatment time may be 1 to 60 seconds. For example, in case of the wafer having the OSF region (the entire plane is the OSF region, the mixed region of the OSF region and Nv region, or the mixed region of the OSF region and the N region.), the heat treatment is particularly preferably performed for 10 to 60 seconds. The heat treatment time can be appropriately adjusted in the above-described range every time according to the size of the OSF nucleus of the silicon single crystal 21. For example, when the size of the OSF nucleus is relatively large from the beginning, a keeping time may be set to a relatively long. An appropriate heat treatment time can be set from the viewpoint of the generation of the slip dislocations, cost, the prevention of the decrease in the oxygen concentration due to the outward diffusion.
On the other hand, in case of performing the rapid thermal annealing on the wafer in which the entire plane is the N region and the OSF region do not exist, since it is not necessary to annihilate the OSF nucleus, it is enough to perform a heat treatment for a short time (1 to 60 seconds) than the heat treatment time. The keeping time may be thus set according to the size of the grown-in oxide precipitates present in the N region, and Particularly Nv region. In this case, equally, an appropriate heat treatment time can be set from the viewpoint of the generation of the slip dislocations, cost, the prevention of the decrease in the oxygen concentration due to the outward diffusion.

By performing the above-described rapid thermal annealing, the annealed wafer 1 in which the RIE defects are annihilated from the region having at least a depth of 1 µm from the wafer surface can be produced, and the hillocks are not formed during forming the groove of the STI. Moreover, the adjustment of the heat treatment time of the rapid thermal annealing enables the region where the RIE defects do not exist in the region having a depth of 5 µm to be obtained.
Moreover, the good chip yield of the TDDB characteristic is superior and the region where the oxygen concentration is decreased due to the outward diffusion from the surface can be limited to within 3 µm, further 2 µm, or 1 µm from the wafer surface. The wafer in which the strength is not decreased in the wafer surface layer can be readily obtained by removing a slight surface layer portion by polishing and the like, as needed. The above-described surface layer can be polished in consideration for the region where the RIE defects do not exist. The wafer can therefore endure the stress generated at the bottom of the STI during the fabrication of devices and the slip dislocations can be suppressed.

A image pickup device, such as a CCD and a CMOS image sensor, can be fabricated by using the annealed wafer produced by the method for producing an annealed wafer according to the present invention. The hillocks can be prevented from being formed during etching due to the defects relevant to oxygen and oxide precipitates by using the annealed wafer according to the present invention as a material of devices requiring a process of etching by the dry etching processing, which is typified by the STI. As a result, it can be etched uniformly.

Hereinafter, the present invention will be explained in more detail based on Examples and Comparative Examples, but the present invention is not restricted thereto.

### (Examples 1 to 6, Comparative Examples 1 to 8)

With the single crystal pulling apparatus shown in FIG. 3, silicon single crystal ingots having various defects regions (a diameter of 12 inches (300 mm), orientation <100>, a conductive type of p-type) were grown while applying a transverse magnetic field by the MCZ method. With the rapidly heating and rapidly cooling apparatus shown in FIG. 5 (here, VANTAGE made by AMAT Inc.), silicon single crystal wafers sliced from the ingots were rapidly heated from a room temperature at a temperature-increasing rate of 50°C/s under an Ar gas atmosphere, kept at a maximum temperature of 1200 to 1350°C for 1 to 10 seconds, and thereafter rapidly cooled at a temperature-decreasing rate of 50°C/s.
It is to be noted that the same result as FIG. 4 was obtained in the preliminary examination relevant to the relation between the growth rate and defect region of the silicon single crystal ingot, and the ingots having a desired defect were grown on the basis of the relationship in the main examination.

Conditions of each Example and Comparative Example were as follows. The method for producing an annealed wafer according to the present invention was carried out in Examples 1 to 6.

### (Example 1) (OSF + Nv)

Pulling Rate: 0.585 mm/min, RTP Processing Temperature: 1320°C, RTP Keeping Time: 10 seconds (Example 2) (OSF + Nv)
Pulling Rate: 0.585 mm/min, RTP Processing Temperature: 1350°C, RTP Keeping Time: 10 seconds (Example 3) (Nv + Ni)
Pulling Rate: 0.510 mm/min, RTP Processing Temperature: 1320°C, RTP Keeping Time: 10 seconds (Example 4) (Nv + Ni)
Pulling Rate: 0.510 mm/min, RTP Processing Temperature: 1350°C, RTP Keeping Time: 10 seconds (Example 5) (Nv + Ni)
Pulling Rate: 0.510 mm/min, RTP Processing Temperature: 1320°C, RTP Keeping Time: 1 seconds (Example 6) (Nv + Ni)
Pulling Rate: 0.510 mm/min, RTP Processing Temperature: 1320°C, RTP Keeping Time: 5 seconds

### (Comparative Example 1) (OSF + Nv)

Pulling Rate: 0.585 mm/min, RTP Processing: none (Comparative Example 2) (OSF + Nv)
Pulling Rate: 0.585 mm/min, RTP Processing Temperature: 1250°C, RTP Keeping Time: 10 seconds (Comparative Example 3) (OSF + Nv)
Pulling Rate: 0.585 mm/min, RTP Processing Temperature: 1270°C, RTP Keeping Time: 10 seconds (Comparative Example 4) (OSF + Nv)
Pulling Rate: 0.585 mm/min, RTP Processing Temperature: 1290°C, RTP Keeping Time: 10 seconds (Comparative Example 5) (Nv + Ni)
Pulling Rate: 0.510 mm/min, RTP Processing: none (Comparative Example 6) (Nv + Ni)
Pulling Rate: 0.510 mm/min, RTP Processing Temperature: 1250°C, RTP Keeping Time: 10 seconds (Comparative Example 7) (Nv + Ni)
Pulling Rate: 0.510 mm/min, RTP Processing Temperature: 1270°C, RTP Keeping Time: 10 seconds (Comparative Example 8) (Nv + Ni)
Pulling Rate: 0.510 mm/min, RTP Processing Temperature: 1290°C, RTP Keeping Time: 10 seconds

After the end of the RTP processing, when the wafers were taken out at a temperature of around 400°C, a very thin oxide film was formed, and therefore each of the wafers was thereafter immersed in 5% HF to remove the oxide film formed on the surface by the RTP processing. Then, samples in which the surface thereof was polished by approximately 1 µm were produced by three wafers.
A first sample was subjected to the OSF heat treatment at 1100°C for 1 hour under a wet oxygen atmosphere and thereafter to the secco-etching, and the OSFs thereof were evaluated with a microscope.
A second sample was etched with a magnetron RIE apparatus (Centura made by Applied Materials Inc.). Hillocks after the etching were measured by a laser scattering type foreign body inspection apparatus (SP1 made by KLA-Tencor Co., Ltd.). The number of the hillocks were measured with an electron microscope to calculate defect density.

In case of a third sample, the TDDB characteristic, which is oxide dielectric breakdown voltage characteristics, was evaluated. The MOS structure used for the evaluation was a thickness of the gate oxide film of 25 nm, and an electrode area of 4 mm². The criteria of α, β, and γ modes was initial breakdown, less than 5C/cm², and 5C/cm² or more, respectively.

Table 1 shows the measurement results of the OSF density, the defect density detected by the RIE method, and the good chip yield of γ mode of the TDDB of each of the samples. In Examples 1 to 6, the annealed wafer according to the present invention was able to be obtained.

**(Table 1)**

| | DEFECT REGION | RTP PROCESSING TEMPERATURE (°C) | RTP KEEPING TIME (s) | OSF (pieces/cm²) | RIE DEFECT DENSITY (pieces/cm²) | TDDB γ MODE GOOD CHIP YIELD (%) |
|---|---|---|---|---|---|---|
| COMPARATIVE EXAMPLE 1 | OSF+Nv | NONE | - | 63 | 139 | 48 |
| COMPARATIVE EXAMPLE 2 | | 1250 | 10 | 25 | 141 | 41 |
| COMPARATIVE EXAMPLE 3 | | 1270 | 10 | 15 | 83 | 45 |
| COMPARATIVE EXAMPLE 4 | | 1290 | 10 | 0 | 49 | 52 |
| EXAMPLE 1 | | 1320 | 10 | 0 | 0 | 80 |
| EXAMPLE 2 | | 1350 | 10 | 0 | 0 | 93 |
| COMPARATIVE EXAMPLE 5 | Nv+Ni | NONE | - | 0 | 210 | 92 |
| COMPARATIVE EXAMPLE 6 | | 1250 | 10 | 0 | 191 | 53 |
| COMPARATIVE EXAMPLE 7 | | 1270 | 10 | 0 | 177 | 60 |
| COMPARATIVE EXAMPLE 8 | | 1290 | 10 | 0 | 62 | 73 |
| EXAMPLE 3 | | 1320 | 10 | 0 | 0 | 93 |
| EXAMPLE 4 | | 1350 | 10 | 0 | 0 | 97 |
| EXAMPLE 5 | | 1320 | 1 | 0 | 0 | 86 |
| EXAMPLE 6 | | 1320 | 5 | 0 | 0 | 90 |

As is obvious from Table 1, with regard to the OSF plus Nv wafer, as the RTP temperature became higher, the OSF density after the RTP processing was rapidly decreased, and the OSFs were completely annihilated at 1290°C. As the RTP temperature became higher, the RIE defects were also decreased. It was, however, revealed that the decrease was more gradual than the OSFs, and the RIE defects hardly annihilated particularly in a temperature range of 1270°C or less. When the RTP temperature was 1290°C or more, the RIE defects were rapidly decreased. When the RTP processing was performed at a higher temperature than 1300°C, the RIE defects were completely annihilated. The good chip yield of the TDDB was hardly improved at a RTP temperature of 1290°C or less. However, the good chip yield was rapidly recovered at a RTP temperature of 1320°C or more, at which the RIE defects were completely annihilated.
On the other hand, in case of the Nv plus Ni wafer, the OSFs were not generated at all RTP temperatures. As the RTP temperature became higher, the RIE defects were also gradually decreased in this case, and completely annihilated in all the cases of the rapid thermal annealing for 1 to 10 seconds in the RTP processing at 1320°C. At the same time, the good chip yield of the TDDB was recovered to 80% or more.

In the event that the RTP process was not carried out (Comparative Example 5), the good chip yield of the TDDB was a high value of 92% although the RIE defects had a high density of 210 pieces/cm².
The cause of this is considered that the size of defects was small although the density of RIE defects was high, or the oxide precipitates were not in the form that could deteriorate the TDDB characteristic.
According to a classical nucleus formation theory, it has been known that the precipitate having a larger size than a critical size at the heat treatment temperature is not annihilated but grown, and the precipitate having a smaller size than the critical size is annihilated.
Since the size of the grown-in oxide precipitates present in the Nv region, namely, the RIE defects was larger than the critical size at 1290°C, the precipitates were grown by performing the RTP at 1300°C or less. Alternatively, the following can be considered. Since Va was injected and frozen in the bulk by the RTP processing under an Ar atmosphere and the concentration was increased in proportion to a high temperature, there is the effect of the RTP processing on the annihilation and shrink of the defects and the defects that could deteriorate the TDDB characteristic was generated by the injection of Va. The latter more affected than the former at 1300°C or less, and the TDDB characteristic was thereby deteriorated. On the other hand, the former more affected than the latter at a temperature more than 1300°C, and the TDDB characteristic was thereby improved.

Moreover, with regard to the TDDB characteristic, it was revealed as follows. In all the cases of a RTP processing temperature of 1300°C or less (Comparative Examples 1 to 8), the good chip yield of γ mode of the TDDB characteristic was decreased once by the RTP processing at 1250°C, and thereafter it was hardly recovered and it remained decreased, particularly in case of the OSF plus Nv wafer.
It can be considered that since the grown-in defects did not exist but only the grown-in oxide precipitates existed in the Nv plus Ni wafer, the TDDB characteristic was recovered at a lower temperature, and therefore the Nv plus Ni wafer had a relatively higher good chip yield at 1290°C in comparison with the OSF plus Nv wafer including the OSF nucleus, which are the grown-in defects.
However, the good chip yield of γ mode of the TDDB characteristic was 73% when the RTP processing was performed at 1290°C. It was revealed that the RTP processing needed to be performed at a higher temperature than 1300°C to recover completely.

On the other hand, in the case of performing the RTP processing at a temperature of more than 1300°C (Examples 1 to 6), the good chip yield of γ mode of the TDDB characteristic was 80% or more, and it was revealed that it was sufficiently recovered. The RIE defects were also annihilated.
With regard to the RTP keeping time, in case of the OSF plus Nv wafer, the γ mode became 80% in condition of a temperature of 1320°C and a keeping time of 10 seconds. It is thus preferably kept at a higher temperature of 1300°C for 10 seconds or more in order to more surely obtain the oxide dielectric breakdown voltage sufficiently. On the other hand, in case of the Nv plus Ni wafer, the good chip yield of γ mode was 86% even at 1320°C for a keeping time of 1 second, and a sufficient high good chip yield was thus able to be obtained. This was caused as follows. Since the OSF region was not included as described above and thereby the OSF nucleuses did not exist in the wafer bulk from the beginning, it is only necessary to dissolve the grown-in oxide precipitates present in the N region, and particularly the Nv region.

### (Examples 7 to 9, Reference Example 1).

On the basis of the relationship between the growth rate and defect region of the silicon single crystal ingot, shown in FIG. 4, there were prepared six pieces of each of the OSF plus Nv wafer and the Nv plus Ni wafer. With the rapidly heating and rapidly cooling apparatus shown in FIG. 5 (here, VANTAGE made by AMAT Inc.), the wafers were rapidly heated from a room temperature at a temperature-increasing rate of 50°C/s under an Ar gas atmosphere, kept at a maximum temperature of 1320°C for 10 seconds, and thereafter rapidly cooled at a temperature-decreasing rate of 50°C/s.
After the end of the RTP processing when the wafers were taken out at a temperature of around 400°C, a very thin oxide film was formed, and therefore each of the wafers was thereafter immersed in 5% HF to remove the oxide film formed on the surface by the RTP processing.

Then, the surface of three OSF plus Nv wafers were polished by 5 µm as Sample-1 (Example 7).
The surface of the other three OSF plus Nv wafers were polished by 20 µm as Sample-2 (Reference Example 1).
The surface of three Nv plus Ni wafers were polished by 5 µm as Sample-3 (Example 8).
The surface of the other three Nv plus Ni wafers were polished by 20 µm as Sample-4 (Example 9).

A first sample of each of Sample-1 to Sample-4 was subjected to the OSF heat treatment at 1100°C for 1 hour under a wet oxygen atmosphere, and to the secco-etching. The OSF thereof was evaluated with a microscope.
A second sample was etched with a magnetron RIE apparatus (Centura made be Applied Materials Inc.). The hillocks after etching were measured by a laser scattering type foreign body inspection apparatus (SP1 made by KLA-Tencor Co., Ltd.). The number of the hillocks was measured with an electron microscope to calculate defect density.

In case of a third sample, the TDDB characteristic, which is oxide dielectric breakdown voltage characteristics, was evaluated. The MOS structure used for the evaluation was a thickness of the gate oxide film of 25 nm, and an electrode area of 4 mm². The criteria of α, β, and γ modes was initial breakdown, less than 5C/cm², and 5C/cm² or more, respectively.

Table 2 shows the measurement results of the OSF density, the defect density detected by the RIE method, and the good chip yield of γ mode of the TDDB of each of the samples. In Examples 7 to 9, the annealed wafer according to the present invention was obtained.

**(Table 2)**

| | DEFECT REGION | RTP PROCESSING TEMPERATURE (°C) | POLISHING STOCK REMOVAL AFTER RTP (µm) | OSF (pieces/em²) | RIE DEFECT DENSITY (pieces/cm²) | TDDB γ MODE GOOD CHIP YIELD (%) |
|---|---|---|---|---|---|---|
| EXAMPLE 7 | OSF+Nv | 1320 | 5 | 0 | 0 | 81 |
| REFERENCE EXAMPLE 1 | | 1320 | 20 | 0 | 70 | 58 |
| EXAMPLE 8 | Nv+Ni | 1320 | 5 | 0 | 0 | 96 |
| EXAMPLE 9 | | 1320 | 20 | 0 | 0 | 99 |

As is obvious from the result, in case of using the OSF plus Nv wafer, the RIE defects were completely annihilated and the good chip yield of the TDDB was also good in Example 7 in which the surface was polished by 5 µm after the RTP. On the other hand, the RIE defects were appeared in the surface and the good chip yield of the TDDB was also deteriorated to 58% in Reference Example 1 in which the surface was polished by 20 µm.
From this result, it was revealed that, in the case of performing the RTP (for 10 seconds) on the OSF plus Nv wafer at a higher temperature than 1300°C, the RIE defects within a range of at least 5 µm from the surface can be annihilated.
It is to be noted that, in case of Reference Example 1, the RIE defects did not exist within a depth of at least 5 µm from the surface as well as Example 7 but the RIE defects were not annihilated sufficiently at a depth of 20 µm from the surface due to lack of the heat treatment time of the rapid thermal annealing. Appropriate conditions may be set in consideration for the depth of region required as a defect-free region, the heat treatment time of the rapid thermal annealing, and the like.

On the other hand, in the case of performing the RTP processing in the Nv plus Ni wafer, the RIE defects did not appear on the surface even when the surface was polished by 20 µm. It was revealed from the result that, in case of the wafer in which the wafer entire plane was the N region, the RIE defects can be annihilated over a wafer depth direction (up to at least 20 µm from the surface) by the RTP processing at a higher temperature than 1300°C even for a heat treatment time of 10 seconds.

### (Example 10, Comparative Example 9)

On the basis of the relationship between the growth rate and defect region of the silicon single crystal ingot, shown in FIG. 4, there were prepared four Nv plus Ni wafers. Two of them were introduced into a normal vertical furnace at 700°C under an Ar atmosphere. The wafers were thereafter heated to 1200°C at a temperature increasing rate of 5°C/min, kept at 1200°C for 1 hour, and cooled to 700°C at a temperature decreasing rate of 3°C/min. The wafers were thereafter taken out from the furnace. In this case, a very thin oxide film was formed, and therefore each of the wafers was immersed in 5% HF to remove the oxide film formed on the surface by the heat treatment to obtain samples (Comparative Example 9).

The other two wafers were rapidly heated from a room temperature at a temperature-increasing rate of 50°C/s under an Ar gas atmosphere with a commercial rapidly heating and rapidly cooling apparatus (VANTAGE made by AMAT Inc.), kept at 1320°C for 10 seconds, and rapidly cooled at a temperature-decreasing rate of 50°C/s.
After the end of the RTP processing, when the wafers were taken out at a temperature of around 400°C, a very thin oxide film was formed, and therefore each of the wafers was thereafter immersed in 5% HF to remove the oxide film formed on the surface by the RTP processing to obtain samples (Example 10).
A first sample of each of them was used for evaluating the TDDB characteristic, and a second sample was used for measuring oxygen distribution in a depth direction by using SIMS.
Table 3 shows the result of the TDDB evaluation. FIG. 6 shows oxygen concentration profiles.

**(Table 3)**

| | DEFECT REGION | HEAT TREATMENT APPARATUS | HEAT TREATMENT | TDDB γ MODE GOOD CHIP YIELD (%) |
|---|---|---|---|---|
| COMPARATIVE EXAMPLE 9 | Nv+Ni | VERTICAL FURNACE | 1200°C, 1 h | 100 |
| EXAMPLE 10 | | RAPIDLY HEATING AND RAPIDLY COOLING APPARATUS | 1320°C, 10 sec | 100 |

In all the cases, the good chip yield of γ mode of the TDDB characteristic was 100%, and good.
As compared with the oxygen concentration distribution in a depth direction, as shown in FIG. 6, the region where the oxygen concentration was decreased in the surface layer had a depth of only approximately 1 µm or at most approximately 2 µm, and moreover the amount of the decrease thereof was very small in Example 10. The decrease in the wafer strength in this case can be disregarded. Moreover it was revealed that the oxygen concentration was completely uniform at a position deeper than 1 µm or 2 µm from the wafer surface layer. In the case of performing the RTP processing at a high temperature, the region where the oxygen concentration was decreased expanded somewhat, but the region was approximately 3 µm at most, since the processing time was very short. The portion where the oxygen concentration was decreased on the surface layer can be therefore completely removed by polishing the surface slightly after the RTP processing, and a completely uniform oxygen concentration distribution profile in a depth direction can be obtained. A high quality annealed wafer in which the TDDB characteristic is superior and the oxygen concentration is not decreased can be thus obtained readily at low cost.

On the other hand, with regard to the annealed wafer subjected to the heat treatment with the vertical furnace in Comparative Example 9, the oxygen concentration was greatly decreased in a range of 20 µm from the surface, and the strength was decreased in this region.
The region where the oxygen concentration was decreased can be removed by polishing after the heat treatment. However, it needs to be polished by 20 µm or more, and thereby the productivity and production cost greatly increase.

As explained in detail, the annealed wafer according to the present invention has a defect-free region with very high quality, in which the grown-in oxide precipitates, the RIE defects, and the OSF nucleuses, which are the grown-in defects do not exist in the region of at least 1 µm or more, and particularly 5 µm or more (even when the region where the oxygen concentration was decreased is removed by 1 to 3 µm, it has a depth of 2 to 4 µm) from the surface layer. The TDDB characteristic, which is long-term reliability of the oxide film, is therefore good (moreover, the good chip yield is 80% or more), and in addition to this, when the groove is formed by utilizing the deference of an etching rate between silicon oxide and silicon (the etching rate of silicon is higher than that of silicon oxide) with a dry etching apparatus in a device process, the defects and precipitates relevant to oxygen do not exist, and the hillocks having these as a vertex are not formed. As a result, the etching is uniformly performed.
The groove can be therefore uniformly formed with good quality.

Moreover, since the decrease in the oxygen concentration in the surface layer is so small that it can be disregarded (within a depth of 1 to 3 µm) or the decrease can be completely disregarded, the decrease in the strength of the wafer surface layer, in which a device is to be formed, is not generated basically, or the region where the strength is decreased can be removed by slightly polishing. The slip dislocations can be prevented which are due to the stress generated by forming a device structure.

Moreover, the method of performing the RTP processing at a higher temperature than 1300°C enables not only the annihilation of the grown-in defects, the grown-in oxide precipitates, and the RIE defects but also the acceleration or suppression of the BMD density to be generated by a heat treatment in a device process, by means of appropriately selecting the atmosphere at the RTP processing.

It is to be noted that the present invention is not restricted to the foregoing embodiment. The embodiment is just an exemplification, and any examples that have substantially the same feature and demonstrate the same functions and effects as those in the technical concept described in claims of the present invention are included in the technical scope of the present invention.

## Claims

1. An annealed wafer obtained by performing rapid thermal annealing on a silicon single crystal wafer sliced from a silicon single crystal ingot in which an entire plane is an OSF region, an N region outside an OSF region, or a mixed region thereof, the silicon single crystal ingot being grown by the Czochralski method, wherein
RIE defects do not exist in a region having at least a depth of 1 µm from a wafer surface, a good chip yield of a TDDB characteristic is 80% or more, and a depth of a region where an oxygen concentration is decreased due to outward diffusion of the surface is within 3 µm from the wafer surface.

2. The annealed wafer according to claim 1, wherein the oxygen concentration of the annealed wafer is uniform in a region having a depth deeper than that of 3 µm from the wafer surface.

3. The annealed wafer according to claim 1 or claim 2, wherein the silicon single crystal wafer to be subjected to the rapid thermal annealing is sliced from a silicon single crystal ingot in which an entire plane is an Nv region, an Ni region, a mixed region thereof, or a mixed region of the OSF region and the Nv region.

4. The annealed wafer according to any one of claims 1 to 3, wherein the RIE defects do not exist in a region having at least a depth of 5 µm from the wafer surface.

5. The annealed wafer according to any one of claims 1 to 4, wherein the depth of the region where an oxygen concentration is decreased due to outward diffusion of the surface is within 2 µm from the wafer surface.

6. The annealed wafer according to claim 5, wherein the oxygen concentration of the annealed wafer is uniform in a region having a depth deeper than that of 2 µm from the wafer surface.

7. A method for producing an annealed wafer, including the steps of growing a silicon single crystal ingot by the Czochralski method, and performing rapid thermal annealing on a silicon single crystal wafer sliced from the silicon single crystal ingot, comprising
growing the silicon single crystal ingot while controlling a pulling rate in such a manner that an entire plane becomes an OSF region, an N region outside an OSF region, or a mixed region thereof,
performing, on the silicon single crystal wafer sliced from the silicon single crystal ingot, the rapid thermal annealing at a temperature from more than 1300°C to 1400°C or less for 1 to 60 seconds with a rapidly heating and rapidly cooling apparatus, and thereby
producing the annealed wafer in which RIE defects are annihilated from a region having at least a depth of 1 µm from a wafer surface.

8. The method for producing an annealed wafer according to claim 7, wherein the silicon single crystal wafer to be subjected to the rapid thermal annealing is sliced from a silicon single crystal ingot in which an entire plane is an Nv region, an Ni region, or a mixed region thereof.

9. The method for producing an annealed wafer according to claim 7, wherein the silicon single crystal wafer to be subjected to the rapid thermal annealing is sliced from a silicon single crystal ingot in which an entire plane is an OSF region, a mixed region of the OSF region and the Nv region, or a mixed region of the OSF region and the N region, and the rapid thermal annealing is performed for 10 to 60 seconds.

10. The method for producing an annealed wafer according to any one of claims 7 to 9, wherein the RIE defects are annihilated from a region having at least a depth of 5 µm from the wafer surface.

11. The method for producing an annealed wafer according to any one of claims 7 to 10, wherein the annealed wafer is produced in such a manner that a depth of a region where an oxygen concentration is decreased due to outward diffusion of the surface is within 3 µm from the wafer surface.

12. The method for producing an annealed wafer according to claim 10, wherein the annealed wafer is produced in such a manner that a depth of a region where an oxygen concentration is decreased due to outward diffusion of the surface is within 2 µm from the wafer surface.

13. The method for producing an annealed wafer according to any one of claims 7 to 12, wherein the silicon single crystal wafer to be subjected to the rapid thermal annealing has an oxygen concentration of not lower than 4×10¹⁷ and not higher than 9×10¹⁷ atoms/cm³ (JEIDA).

14. The method for producing an annealed wafer according to any one of claims 7 to 13, wherein the silicon single crystal wafer to be subjected to the rapid thermal annealing has a nitrogen concentration of between 1×10¹¹ and 1×10¹⁵ atoms/cm³ and/or has a carbon concentration of between 1×10¹⁶ and 1×10¹⁷ atoms/cm³.

15. A method for fabricating a device, wherein, when the device is fabricated by using the annealed wafer produced by the method for producing an annealed wafer according to any one of claims 7 to 14, dry etching is performed.

16. The method for fabricating a device according to claim 15, wherein the device is an image pickup device.
